# EUROPEAN PATENT APPLICATION

(11) **EP 3 916 729 A1**
(43) Date of publication of application: **01.12.2021**
(21) Application number: 20315259.0
(22) Date of filing: 26.05.2020
(51) Int. Cl.: G11C 11/16, G11C 11/18

(54) **MAGNETIC MEMORY ELEMENT HAVING DETERMINISTIC SWITCHING AND METHOD FOR WRITING SUCH MAGNETIC MEMORY ELEMENT**

(71) Applicant: Antaios, 38240 Meylan (FR)
(72) Inventor: Drouard, Marc, 26000 Valence (FR); Martin, Sylvain, 38100 Grenoble (FR)
(74) Representative: P&TS SA (AG, Ltd.)

(57) **Abstract**

Magnetic memory element (1), comprising a magnetic tunnel junction MTJ (2) including a reference layer (21) having a reference magnetisation (210), a tunnel barrier (22) and a storage layer (23) having a storage magnetization (230), the reference and storage layers (21, 23) having perpendicular magnetic anisotropy and the storage magnetization (230) is switchable between a first and second stable states perpendicular to a plane of the storage layer (23); a current layer (30) configured to pass a writing current (31) in a first direction (x) oriented substantially parallel to the plane of the storage layer (23), the writing current (31) being adapted for switching the storage magnetization (230) by a spin orbit torque (SOT) interaction. The magnetic memory element (1) further comprises a polarizing layer (4) comprising an electric polarization (40) having at least a component oriented in a second direction (y) orthogonal to the first direction (x) and in the plane of the current layer (30), the electric polarization (40) allowing deterministically switching of the storage magnetization (230) when the writing current (31) is passed.

## Description

### Technical domain

The present disclosure relates to a magnetic memory element and more particularly a magnetic memory element that is deterministically switchable by a writing current using a spin orbit torque (SOT) interaction. The present disclosure further relates to a method for performing a write operation in the magnetic memory element.

### Related art

In a magnetic memory element such as in a magnetic random access memory (MRAM) cell, data is read and written using characteristics in which a resistance of a magnetic tunnel junction (MTJ) changes when magnetization directions of two ferromagnetic layers sandwiching an insulating layer change. As writing methods for MRAMs, a method in which writing (magnetization reversal) is performed using a magnetic field produced by a current and a method in which writing (magnetization reversal) is performed using a spin transfer torque (STT) occurring when a current flows in a lamination direction of a magnetoresistance effect element are known. Magnetization reversals of MTJs using an STT can be efficient in view of energy efficiency, but a reversal current density causing magnetization reversal to be performed induces high voltage across the MTJ thus lowering the MTJ lifetime. In terms of a long lifetime of MTJs, it is desirable that reversal current densities be low or to avoid having the reversal currents to flow through the MTJ.

Therefore, in recent years, magnetization reversal in which magnetization is reversed by a mechanism different from an STT as a means for eliminating a writing current having to flow through the MTJ in which a current layer adjacent to the MTJ generates a spin current caused by a SOT interaction, has been attracting attention.

A conventional SOT-based memory cell comprises a tunnel barrier layer sandwiched between a first ferromagnetic layer having a first magnetization and a second ferromagnetic layer having a second magnetization. The second magnetization can be switched by passing a writing current in a current line in contact with the second magnetization. The SOT based switching allows for using separate read- and write-paths which is beneficial for a long life of the memory cell. In the case the first and second magnetizations are perpendicular to the plane of the layers, such as in SOT-switching based magnetoresistive memory cell that are required for high-density memory, a magnetic field having at least a component parallel to the writing current must be applied in addition to the writing current in order to deterministically switch the second magnetization. However, the need for an external applied field significantly hinders the technological viability of commercial applications.

### Summary

The present disclosure concerns a magnetic memory element comprising a magnetic tunnel junction MTJ including a reference layer having a reference magnetization, a tunnel barrier and a storage layer having a storage magnetization. The reference and storage layers have perpendicular magnetic anisotropy and the storage magnetization is switchable between a first and second stable states perpendicular to a plane of the storage layer. The magnetic memory element further comprises a current layer configured to pass a writing current in a first direction oriented substantially parallel to the plane of the storage layer, the writing current being adapted for switching the storage magnetization by a SOT interaction. The magnetic memory element further comprises a polarizing layer comprising an electric polarization having at least a component oriented in a second direction substantially orthogonal to the first direction, the electric polarization allowing deterministically switching of the storage magnetization when the writing current is passed.

### Short description of the drawings

Exemplar embodiments of the invention are disclosed in the description and illustrated by the drawings in which:
Fig. 1 shows a magnetic memory element, according to an embodiment;
Fig. 2 represents a partial view of the magnetic memory element of Fig. 1, according to an embodiment;
Fig. 3 represents the partial view of the magnetic memory element comprising a polarizing device, according to an embodiment;
Fig. 4 represents the partial view of the magnetic memory element comprising a polarizing device, according to another embodiment;
Fig. 5 represents the partial view of the magnetic memory element comprising a polarizing device, according to yet another embodiment; and
Fig. 6 represents the partial view of the magnetic memory element comprising a polarizing device, according to yet another embodiment.

### Examples of embodiments

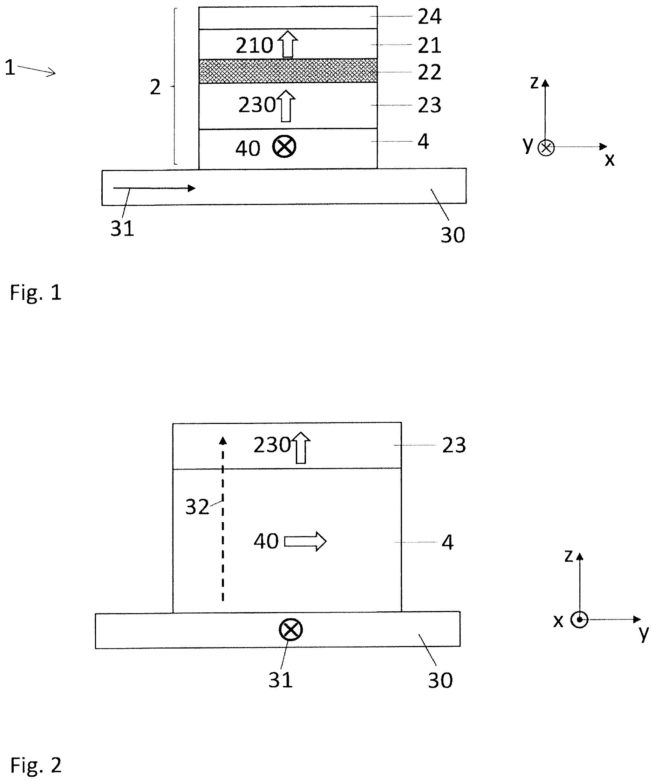

**Fig. 1** shows a magnetic memory element 1, according to an embodiment. The magnetic memory element 1 comprises a magnetic tunnel junction MTJ 2 including a reference layer 21 having a reference magnetisation 210, a tunnel barrier 22 and a storage layer 23 having a storage magnetization 230. The reference and storage layers 21, 23 has perpendicular magnetic anisotropy (PMA) such that the reference magnetization 210 is oriented in a direction substantially perpendicular to the plane (out-of-plane) of the reference layer 21 and the storage magnetization 230 is switchable between a first and second stable magnetic states substantially perpendicular to a plane (out-of-plane) of the storage layer 23.

The magnetic memory element 1 further comprises a current layer 30 configured to pass a writing current 31 in a first direction "x" oriented substantially parallel to the plane of the storage layer 23. The writing current 31 is adapted for switching the storage magnetization 230 by a spin orbit torque (SOT) interaction, during a write operation of the magnetic memory element 1.

The current layer 30 can be made of a material which generates a spin current, for example due to a spin Hall effect and/or Rashba-Edelstein effect, when the writing current 31 flows therethrough. The current layer 30 can comprise any material configured to generate a spin current (for example a pure spin current). Such material is not limited to a material consisting of a single element and may be a conductive material which generates a spin current. More particularly, such material can include but are not limited to Pt, W, Ta, Ir, Ru, Pd, Cu, Au, Bi, Hf, Se, Sb or of an alloy of these elements.

Each of the storage layer 23 and the reference layer 21 can include a single layer. The single-layer storage layer 23 and/or reference layer 21 can comprise Co, Ni, Fe or an alloy of any of these elements alone or in combination, such as CoFe, CoFeB or NiFe. Alternatively, the storage layer 23 and/or the reference layer 21 can comprise a plurality of ferromagnetic layers, a two-layer arrangement such as Co/Ru/CoFeB with the magnetization of Co and CoFeB in the same direction (e.g. a composite ferromagnet) or a SAF structure. The thickness of the storage layer 23 can be between 0.5 nm and 10 nm and preferably between 1 and 3 nm.

The MTJ 2 can further comprise a capping layer 24, possibly including an antiferromagnetic layer exchange coupling the reference magnetization 210 such as to pin it in a predetermined direction. Alternatively, the MTJ 2 can comprise a SAF structure 24 with the reference layer 21. The SAF structure 24 can comprise a metallic non-magnetic spacer layer and a ferromagnetic layer.

The magnetic memory element 1 further comprises a polarizing layer 4 having an electric polarization 40 in a second direction "y" substantially orthogonal to the first direction "x" and in the plane of the current layer 30. The electric polarization 40 generates an electric field that is seen as a magnetic field by passing electrons of the spin current. The electric polarization 40 orients the spin of the passing spin current. The spin current polarized along a third direction "+z" or "-z" will orient the storage magnetization 230 along the third direction "+z" or respectively opposed to the third direction "-z". The electric polarization 40 allows for deterministically switching the storage magnetization 230 from the first to the second magnetization state when the writing current 31 is passed.

Deterministically switching of the storage magnetization 230 can be achieved insofar as the electric polarization 40 has at least a component oriented in the second direction "y". For example, the electric polarization 40 can be oriented in the "y-z" or the "x-y" plane and comprises a component in the second direction "y". Preferably, the electric polarization 40 is completely oriented in the second direction "y".

As will be seen below, the electric polarization 40 can comprise a spontaneous electric polarization that can be reversed in direction by the application of an appropriate electric field or a static electric field induced by an external electric field.

**Fig. 2** represents a partial view of the magnetic memory element 1, showing the current layer 30, the polarizing layer 4 and the storage layer 23. In Fig. 2, the polarizing layer 4 is shown with a greater thickness than the other layers for the sake of clarity. When the writing current 31 is passed in the current layer 30 in the first direction "+x" or in a direction "-x" opposed to the first direction, the spin current at proximity of the current line 30 is polarized in the second direction "+y", respectively in a direction "-y" opposed to the second direction. In the polarizing layer 4 the electric polarization 40 causes the spin current to have a spin polarization comprising at least a component oriented in the third direction "+z", respectively in a direction "-z" opposed to the third direction.

Note that the electric polarization 40 could be oriented in a direction opposite to the one shown in Figs. 1 and 2. The electric polarization 40 orients the spin polarization of the spin current such that the MRAM cell can be written in a deterministic fashion

In an embodiment, the polarizing layer 4 comprises a ferroelectric material. A ferroelectric material has a spontaneous electric polarization 40 (separation of the centre of positive and negative electric charge distribution) that can be reversed by the application of an appropriate bias electric field. Consequently, the ferroelectric polarizing layer 4 can comprises the electric polarization 40 even in the absence of a bias electric field.

In one aspect, the ferroelectric material can comprise, without limitation, one or more of the materials selected among: hafnium oxide (H_{f}O₂), BiFeO₃, *x*Ti*x*O₃, BaTiO₃, ErMnO₃, HoMnO₃, LiNbO₃, PZT Pb(Zrx,Ti1-x)O₃, PbTiO₃, Pb(1-x)La(x)Zr(1-y)Ti(y)O(3) (PLZT), PbMg(1-x)Nb(x)O(3) (PMN), SrBi₂Nb₂O₉ (SBN) or SrBi(2)[Ta(1-x)Nb(x)](2)O(9) (SBTN). The thickness of the polarizing layer 4 can be adjusted such that the spin current remains coherent.

In another embodiment, the polarizing layer 4 comprises a dielectric material. The electric polarization 40 can be induced in a dielectric material by applying an external electric field. The electric polarization 40 exists in the dielectric polarizing layer 4 only in the presence of the external electric field. The latter must then be applied during a write operation of the magnetic memory element 1. In one aspect, the dielectric material can comprise, without limitation, one or more of the materials selected among, but not limited to: SrTiO₃, SiO₂, MgO, AlOx, TiO₂, RuO₂, SiNx or SiOxNy.

The thickness of the polarizing layer 4 can be between 0.1 and 10 nm and preferably between 0.5 and 2 nm or between 0.5 and 1 nm.

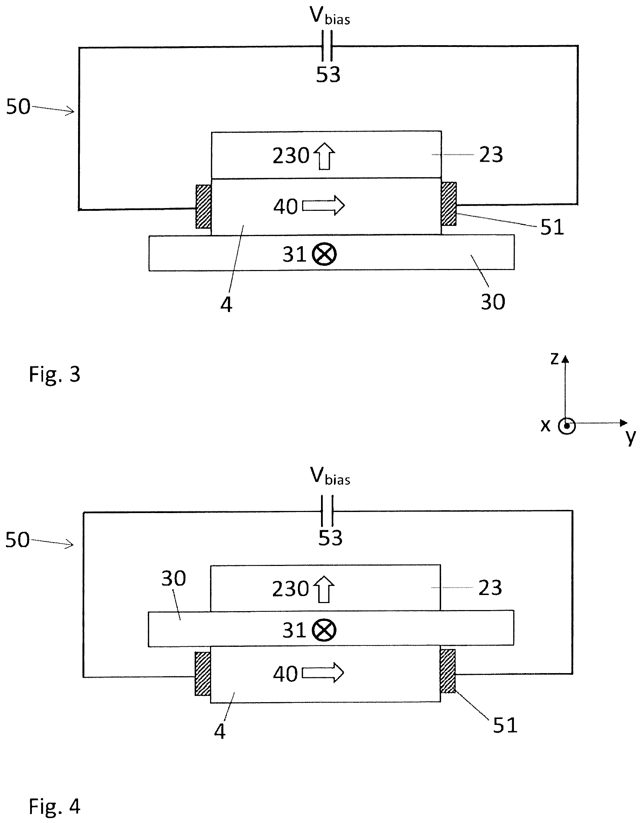

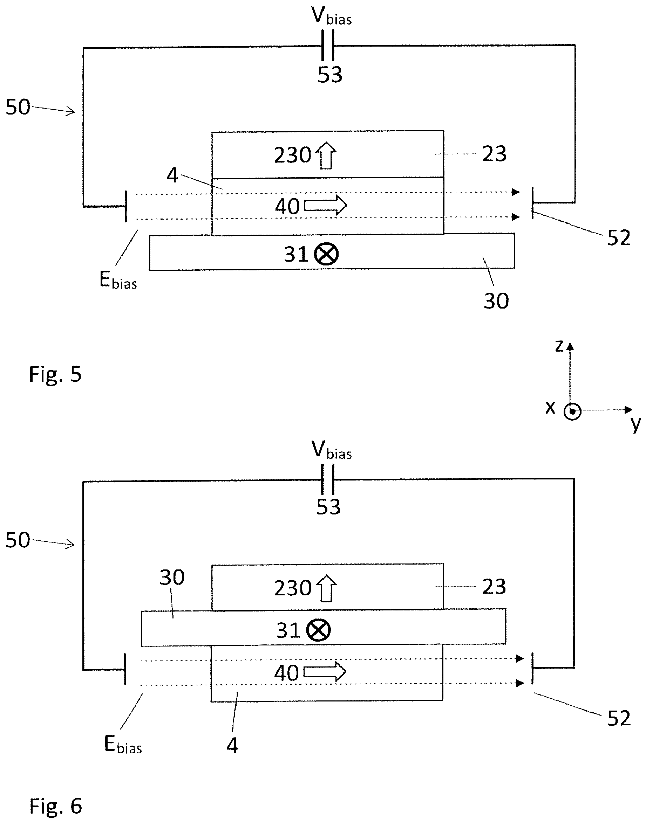

Various arrangements of the polarizing layer 4 can be contemplated within the scope of possible embodiments of the invention. For example, in a first arrangement the polarizing layer 4 is comprised between the current layer 30 and the storage layer 23 (see Figs. 1-3 and 5). In the first arrangement, the polarizing layer 4 is preferably in direct contact with the current layer 30 and in direct contact with the storage layer 23. Alternatively, a second arrangement the current layer 30 is comprised between the polarizing layer 4 and the storage layer 23 (see Figs. 4 and 6). In the second arrangement, the current layer 30 is preferably in direct contact with the storage layer 23 and possibly with the polarizing layer 4. In the second arrangement, a thickness of the current layer 30 can be adjusted such that the polarizing layer 4 can interact with the storage layer 23. For example, the thickness of the current layer 30 can be between 0.5 nm and 200 nm, more particularly between 0.5 nm and 100 nm, or less than 10 nm. Preferably, the thickness of the current layer 30 is between 0.5 nm and 5 nm.

**Fig. 3** represents the partial view of the magnetic memory element 1 comprising a polarizing device 50, according to an embodiment. The polarizing device 50 is configured to apply a bias voltage V_{bias} adapted to induce the electric polarization 40 in the polarizing layer 4. In the configuration of Fig. 3, the polarizing device 50 comprises a voltage source 53 generating the bias voltage V_{bias} and connected to the polarizing layer 4 via electrical contacts 51. The polarizing device 50 is configured to apply the bias voltage V_{bias} such as to induce the electric polarization 40 along the second direction "y". Fig. 3 represents the magnetic memory element 1 with the polarizing layer 4 in the first arrangement.

**Fig. 4** represents the partial view of the magnetic memory element 1 comprising a polarizing device 50, according to another embodiment wherein the polarizing layer 4 is in the second arrangement. Note that in Figs. 3 and 4, the magnetic memory element 1 is represented rotated at 90° in the "x-y" plane relative to the representations of Figs. 1 and 2.

In the case the polarizing layer 4 comprises a ferroelectric material, the induced electric polarization 40 is proportional to the applied bias voltage V_{bias}. Moreover, in a ferroelectric comprising polarizing layer 4, the electric polarization 40 remains in the absence of the bias voltage V_{bias} (the electric polarization 40 is stored in the polarizing layer 4), and the polarizing device 50 can be used only for initializing the electric polarization 40 in the polarizing layer 4 and does not need to be used during a write operation of the magnetic memory element 1. In some circumstances, the polarizing device 50 can be separate of the magnetic memory element 1 and used in combination with the magnetic memory element 1, for example, during an initialization operation.

**Figs. 5** and **6** show the polarizing device 50 according to another embodiment, wherein the polarizing device 50 comprises a voltage source 53 configured to apply an electric field E_{bias} between two capacitor plates 52 such as to induce the electric polarization 40 along the second direction "y". Fig. 5 shows the polarizing layer 4 is in the first arrangement while Fig. 6 shows the polarizing layer 4 in the second arrangement. Note that in Figs. 5 and 6, the magnetic memory element 1 is represented rotated at 90° in the "x-y" plane relative to the representations of Figs. 1 and 2. The polarizing device 50 according to the configuration of Figs 5 and 6 is adapted for the polarizing device 50 comprising a dielectric material.

In the case the polarizing layer 4 comprises a dielectric material, maintaining the electric polarization 40 requires the application of the bias voltage V_{bias} (and thus the electric field E_{bias} between the two capacitor plates 52). Thus, the polarizing device 50 is used during a write operation of the magnetic memory element 1 such that the write operation can be performed in the presence of the electric polarization 40.

The direction of the electric polarization 40 can be inversed by applying a negative or positive bias voltage V_{bias}. It should be noted that the polarizing device 50 can take other forms that the ones shown in Figs. 3 to 6. For example, can comprise a capacitor or any structure with charge trapped or any device adapted of generating an electric field.

In one aspect, the dielectric material has a relative permittivity εᵣ higher than 3.

Various arrangements of the magnetic memory element 1 can be contemplated within the scope of possible embodiments of the invention. In a non-illustrated example, the magnetic memory element 1 can be arranged in an upside-down configuration where the MTJ 2 is arranged below the current layer 30, in comparison to the configuration of Fig. 1.

The present disclosure further pertains to a method of performing a write operation in the magnetic memory element 1. In an embodiment, the method comprises a step of:
providing the electric polarization 40 in the polarizing layer 4, wherein the electric polarization 40 is oriented along the second direction "y";
passing the writing current 31 in the current layer 30, in the first direction "x" substantially orthogonal to the second direction "y", such as to deterministically switch the storage magnetization 230 from a first to a second stable magnetization state.

In one aspect, the polarizing layer 4 comprises a ferroelectric material and the method includes a step of providing the polarizing device 50 and applying a bias voltage V_{bias} to the polarizing layer 4, prior to the step of passing the writing current 31.

In another aspect, the polarizing layer 4 comprises a dielectric material and the method includes a step of providing the polarizing device 50 and applying a bias voltage V_{bias} to the polarizing layer 4 simultaneously with passing the writing current 31. The bias voltage V_{bias} can be applied during a duration being equal or greater than the duration of the passing writing current 31. For example, the duration of the writing current 31 can be between 0.01 ns and 100 ns and preferably between 0.1 ns and 10 ns. The bias voltage V_{bias} should be such that the electric field E_{bias} is between 0.1kV/cm and 1MV/cm and preferably between 1 kV/cm and 100 kV/cm or between 5 and 20 kV/cm.

Switching the storage magnetization 230 from a first to a second stable magnetization state can be performed by inversing the polarity of the writing current 31.

Moreover, switching the storage magnetization 230 from a first to a second stable magnetization state can be further performed by reversing the direction of the electric polarization 40 by applying a negative or positive bias voltage V_{bias}. Here, switching the storage magnetization 230 can be achieved without changing the direction of the writing current 31.

### Reference numbers and symbols

- 1: magnetic memory cell
- 21: reference ferromagnetic layer
- 210: reference magnetization
- 22: tunnel barrier layer
- 23: storage ferromagnetic layer
- 230: storage magnetization
- 24: capping layer
- 30: current layer
- 31: writing current
- 32: spin current
- 4: polarizing layer
- 40: electric polarization
- 50: polarizing device
- 51: electrical contact
- 52: capacitor plate
- 53: voltage source

- εᵣ: relative permittivity
- E_{bias}: electric field
- V_{bias}: bias voltage
- x: first direction
- y: second direction
- z: third direction

## Claims

1. A magnetic memory element (1), comprising:
a magnetic tunnel junction MTJ (2) including a reference layer (21) having a reference magnetisation (210), a tunnel barrier (22) and a storage layer (23) having a storage magnetization (230), the reference and storage layers (21, 23) having perpendicular magnetic anisotropy and the storage magnetization (230) is switchable between a first and second stable states perpendicular to a plane of the storage layer (23);
a current layer (30) configured to pass a writing current (31) in a first direction (x) oriented substantially parallel to the plane of the storage layer (23), the writing current (31) being adapted for switching the storage magnetization (230) by a spin orbit torque (SOT) interaction;
**characterized in that**
the magnetic memory element (1) further comprises a polarizing layer (4) comprising an electric polarization (40) having at least a component oriented in a second direction (y) orthogonal to the first direction (x) and in the plane of the current layer (30), the electric polarization (40) allowing deterministically switching of the storage magnetization (230) when the writing current (31) is passed.

2. The magnetic memory element (1) according to claim 1,
wherein the polarizing layer (4) comprises a ferroelectric material.

3. The magnetic memory element (1) according to claim 2,
wherein the ferroelectric material comprises one or more of the materials selected among: hafnium oxide (H_{f}O₂), BiFeO₃, *x*Ti*x*O₃, BaTiO₃, ErMnO₃, HoMnO₃, LiNbO₃, PZT Pb(Zrx,Ti1-x)O₃, PbTiO₃, Pb(1-x)La(x)Zr(1-y)Ti(y)O(3), PbMg(1-x)Nb(x)O(3), SrBi₂Nb₂O₉ or SrBi(2)[Ta(1-x)Nb(x)](2)O(9).

4. The magnetic memory element (1) according to claim 1,
wherein the polarizing layer (4) comprises a dielectric material.

5. The magnetic memory element (1) according to claim 4,
wherein the dielectric material comprises one or more of the materials selected among: SrTiO₃, SiO₂, MgO, AlOx, TiO₂, RuO₂, SiNx or SiOxNy.

6. The magnetic memory element (1) according to any one of claims 1 to 5,
wherein the polarizing layer (4) has a thickness between 0.1 and 10 nm, preferably between 0.5 and 2 nm or between 0.5 and 1 nm.

7. The magnetic memory element (1) according to any one of claims 1 to 6,
wherein the polarizing layer (4) is between the current layer (30) and the storage layer (23).

8. The magnetic memory element (1) according to any one of claims 1 to 6,
wherein the current layer (30) is between the polarizing layer (4) and the storage layer (23).

9. The magnetic memory element (1) according to any one of claims 1 to 8,
comprising a polarizing device (50) configured to induce the electric polarization (40) in the polarizing layer (4) such that the electric polarization (40) has at least a component oriented along the second direction (y).

10. The magnetic memory element (1) according to claim 9,
wherein the polarizing device (50) comprises a voltage source (53) configured to apply a bias voltage (V_{bias}) and connected to the polarizing layer (4) via electrical contacts (51).

11. The magnetic memory element (1) according to claim 9,
wherein the polarizing device (50) comprises a voltage source (53) configured to apply an electric field (E_{bias}) between two capacitor plates (52).

12. Method for performing a write operation in the magnetic memory element (1) according to any one of claims 1 to 11, comprising:
inducing the electric polarization (40) in the polarizing layer (4), wherein the electric polarization (40) has at least a component oriented along the second direction (y);
passing the writing current (31) in the current layer (30), in the first direction (x) orthogonal to the second direction (y) and in the plane of the current layer (30), such as to deterministically switch the storage magnetization (230) from a first to a second stable magnetization state.

13. The method according to claim 12,
wherein the polarizing layer (4) comprises a ferroelectric material; and wherein inducing the electric polarization (40) comprises providing the polarizing device (50) and applying a bias voltage (V_{bias}) to the polarizing layer (4) prior to passing the writing current (31).

14. The method according to claim 12,
wherein the polarizing layer (4) comprises a dielectric material; and wherein inducing the electric polarization (40) comprises providing the polarizing device (50) and applying an electric field (E_{bias}) to the polarizing layer (4) simultaneously with passing the writing current (31).

15. The method according to any one of claims 12 to 14,
further comprising switching the storage magnetization (230) by reversing the direction of the electric polarization (40).
